# EUROPÄISCHE PATENTSCHRIFT

(11) **EP 2 004 884 B1**
(45) Veröffentlichungstag und Bekanntmachung des Hinweises auf die Patenterteilung: **09.03.2016**
(21) Anmeldenummer: 07722041.6
(22) Anmeldetag: 15.03.2007
(51) Int. Cl.: C30B 29/30, C30B 33/02

(54) **BEHANDLUNG VON KRISTALLEN ZUR VERMEIDUNG OPTISCHEN SCHADENS**
TREATMENT OF CRYSTALS FOR THE PREVENTION OF OPTICAL DAMAGE
TRAITEMENT DE CRISTAUX POUR LA PRÉVENTION DU DOMMAGE OPTIQUE

(30) Priorität: 06.04.2006 DE 102006016201
(43) Veröffentlichungstag der Anmeldung: 24.12.2008
(73) Patentinhaber: Deutsche Telekom AG, 53113 Bonn (DE)
(72) Erfinder: BUSE, Karsten, 53115 Bonn (DE); FALK, Matthias, Palo Alto, CA 94306 (US); WOIKE, Theo, 53879 Euskirchen (DE)
(74) Vertreter: Braun-Dullaeus, Karl-Ulrich
(86) Internationale Anmeldenummer: PCT/DE2007/000468
(87) Internationale Veröffentlichungsnummer: WO 2007/112719

(56) Entgegenhaltungen:
- WO-A-2005/068690
- US-A- 3 932 299
- FALK M ET AL: "Thermo-electric method for nearly complete oxidization of highly iron-doped lithium niobate crystals" APPLIED PHYSICS B ; LASERS AND OPTICS, SPRINGER-VERLAG, BE, Bd. 81, Nr. 6, 1. Oktober 2005 (2005-10-01), Seiten 853-855, XP019337552 ISSN: 1432-0649

## Beschreibung

Die vorliegende Erfindung betrifft ein Verfahren zur Behandlung eines nominell reinen Kristalls mit nichtlinearen optischen Eigenschaften, nämlich eines Lithiumniobat- oder eines Lithiumtantalat-Kristatis, wobei im Kristall dennoch Verunreinigungen durch Fremdatome mit einer Restkonzentration weniger 20 ppm, insbesondere Fe²⁺-Ionen, vorhanden sind, die eine spezifische Absorption von eingestrahltem Licht bewirken, wobei die Fremdatome mittels einer beispielsweise durch Hitzezufuhr unterstützten Oxidation in einen niedrigeren Valenzzustand, insbesondere in Fe³⁺-Ionen, überführt werden, wobei die bei der Oxidation frei werdenden Elektronen durch Anlegen einer elektrischen Spannung aus dem Kristall abgeführt werden. Die Erfindung betrifft zudem optisch nichtlineare Bauteile, die einen derart behandelten Kristall aufweisen.

Nichtlinear optische Kristalle, wie das genannte Lithiumniobat und Lithiumtantalat, werden in Bauteilen für die Laseroptik, beispielsweise in Frequenzverdopplern oder in Frequenzmischern, eingesetzt, wobei für diesen Einsatz eine hohe Reinheit der Kristalle erforderlich ist. Da es jedoch unvermeidlich ist, dass auch bei einer unter höchster Reinheit durchgeführten Züchtung eine geringe Menge von Verunreinigungen in den Kristall gelangt, werden diese Kristalle auch nur als "nominell" rein bezeichnet.

Bei den Verunreinigungen handelt es sich um Ionen, die innerhalb des Kristalls in mehreren Valenzzuständen vorkommen und als Elektronenspender und Fänger wirken können. Dabei ist es für die oben genannten Anwendungen besonders problematisch, dass besonders intensives Licht, insbesondere Laserlicht, an den Ionen eine Umverteilung der Ladung und damit ein Raumladungsfeld bewirken kann. Das Raumladungsfeld bewirkt in elektrooptischen Kristallen eine störende Modulation des Brechungsindex, die für den Lichtstrahl insofern einen "optischen Schaden" darstellt, als der Lichtstrahl im Kristall auffgefächert wird und damit seine Qualität verliert.

So verursacht eine Verunreinigung mit Eisen, das in den Valenzzuständen Fe²⁺ und Fe³⁺ vorkommt, einen Ladungstransport, bei dem das Fe²⁺-Ion ein Elektron abgibt, das in das Leitungsband gelangt, wobei ein Fe³⁺-Ion zurück bleibt und das im Leitungsband freie Elektron von bereits vorhandenen Fe³⁺ Ionen eingefangen wird. Dieser Ladungstransport verursacht einen gravierenden optischen Schaden. Um den Ladungstransport und damit den optischen Schaden zu vermeiden wird versucht, die Verunreinigungen schon beim Züchten zu minimieren. Es hat sich bislang allerdings als unmöglich erwiesen, Kristalle mit einer Restdotierung geringer als 10 ppm zu züchten.

Eine andere Möglichkeit besteht darin, den Kristall nachträglich effektiv zu reinigen, also die ungewollten Dotierungen unschädlich zu machen, indem die Elektronen spendenden Ionen oxidiert, also beispielsweise die Fe²⁺-Ionen in den Fe³⁺-Zustand überführt werden. Die dadurch freiwerdenden, überschüssigen Elektronen werden dann durch Anlegen einer Spannung "ausgewaschen". Solche Verfahren sind als "Oxidation" bekannt, wobei deren reinigende Wirkung durch an den Kristall angelegte hohe Temperaturen und externe Spannungen unterstützt wird. Dabei dient als Maß für den Grad der Oxidation das Konzentrationsverhältnis V von gefüllten zu leeren Störstellen; Im Fall von Eisen also das Konzentrationsverhältnis von Fe²⁺ zu Fe³⁺. Wenn V nun sehr klein ist, kann auch kein Ladungstransport auftreten, da die Elektronenspender fehlen. Entsprechend wird auch kein Raumladungsfeld aufgebaut und der optische Schaden vermieden.

Auch wenn die bekannten Verfahren einen deutlichen Reinigungseffekt haben, so reicht die Reinheit der behandelten Kristalle für Anwendungen mit Laserstrahlen hoher Intensitäten noch nicht aus. Aus diesem Grund ist es bislang auch kaum möglich, bekannte optisch-nichtlineare Bauteile, wie Frequenzverdoppler, Frequenzmischer oder optisch parametrische Oszillatoren (OPOs), im Zusammenhang mit Laserstrahlen hoher Intensität einzusetzen. Der optische Schaden, dem sich diese Laserstrahlen in den Bauteilen ausgesetzt sehen, beeinträchtigen deren Funktionalität in unakzeptablem Maße.

Aufgabe der Erfindung ist es nunmehr, ein Verfahren der "induzierten" Oxidation zu schaffen, das sich einfach und kostengünstig umsetzen lässt und mit dem sich die Kristalle, insbesondere Lithiumniobat und Lithiumtantalat, in bislang nicht erreichtem Maße reinigen lassen, so dass die Absorption auch intensiver Strahlung im Kristall auf ein Minimum reduziert wird. Aufgabe der Erfindung ist es auch, auch bei hohen Lichtintensitäten zuverlässig arbeitende optisch nichtlineare Bauteile zu schaffen.

Diese Aufgaben werden durch das Verfahren mit den kennzeichnenden Merkmalen des Anspruch 1 und durch die Bauteile mit den kennzeichnenden Merkmalen des Anspruch 15 gelöst. Vorteilhafte Ausgestaltungen der Erfindung sind in den jeweiligen Unteransprüchen genannt.

Ein wesentlicher Grundgedanke der Erfindung liegt zunächst darin, den Kristall langsam, nämlich mit einem Temperaturanstieg von weniger als 3 °C pro Minute, insbesondere von weniger als 2,5 °C pro Minute, auf eine vorgegebene Maximaltemperatur aufzuheizen. Diese Maximaltemperatur liegt dabei einerseits oberhalb eines vorgegebenen Schwellwertes und andererseits unterhalb der Curie-Temperatur des Kristalls, die im Falle von Litiumniobat und Litiumtantalat bei etwa 1143°C liegt. Im Übrigen liegt der von Materialspezifika abhängige Schwellwert am Ende eines für den Kristall spezifischen Temperaturintervalls, in dem sich der Prozess der Ionenwanderung ausbildet und zumindest nahezu abgeschlossen wird. Bis zum Erreichen des Schwellwertes geschieht eine durch die angelegte Spannung verursachte Wanderung von im Kristall vorhandenen Ionen, insbesondere von Li⁺-Ionen, hin zur Oberfläche des Kristalls. Ein wesentlicher Aspekt der Erfindung liegt somit darin, die äußeren Parameter für die durch Temperatur und angelegte Spannung induzierte Oxidation so einzustellen, dass die Ionenwanderung in möglichst großem Umfang stattfindet.

Dabei ist es für die Effektivität der Oxidation besonders vorteilhaft, wenn der Temperaturanstieg zumindest innerhalb dieses Temperaturintervalls kontinuierlich und stetig erfolgt. Unter solch idealen Verhältnissen kann die Ionenwanderung zumindest weitgehend abgeschlossen werden. Anderenfalls besteht die Gefahr, dass die Ionenwanderung unterbrochen wird.

Eine bemerkenswerte Tatsache, nämlich dass die Größe des zu wählenden Temperaturanstiegs in Zusammenhang mit der Konzentration der Fremdatome steht und umso kleiner zu wählen ist, je kleiner die verbleibende Restkonzentration ist, konnte anhand von Untersuchungen gezeigt werden. Der Temperaturanstieg bei der Oxidation an nominell reinen Kristallen sollte demnach einen Temperaturgradienten von 2,5°C pro Minute nicht wesentlich übersteigen.

Da die Verhältnisse, die zu einer möglichst vollständigen Oxidation führen, also die bei der Behandlung einzustellenden Parameter, materialspezifisch sind, ist es ein weiterer wesentlicher Aspekt der Erfindung, Untersuchungsmethoden zur Feststellung der Materialspezifika vorzuschlagen. So wird zunächst der wichtige Parameter "Schwellwert" anhand von Untersuchungen an gezielt dotierten Referenzkristallen der gleichen Art bestimmt. Erfindungsgemäß wird dann der Schwellwert und werden die anderen an dotierten Referenzkristallen gefundenen Parameter auf die nominell reinen Kristalle übertragen, wobei der Grad der Dotierung der Referenzkristalle insbesondere größer als 0,1 wt% ist.

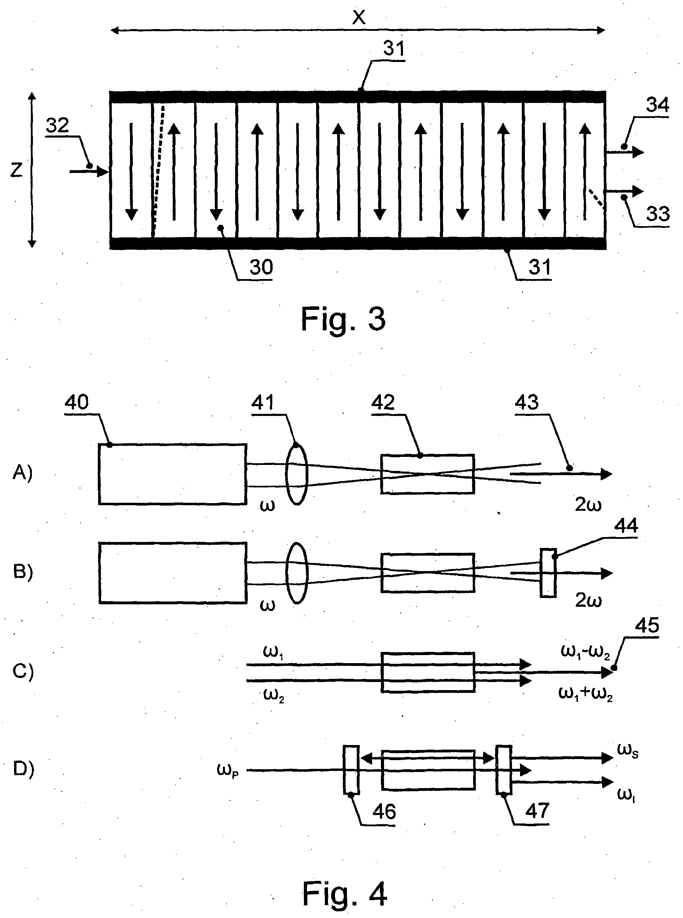

In diesem Zusammenhang sei auf den Artikel "Thermo-electric method for nearly complete oxidation of highly iron-doped lithium niobate crystals" von M. Falk und K. Buse aus Appl. Phys. B81, 853-855 (2005) verwiesen, in dem ein Verfahren zur Oxidation hoch dotierter Kristalle veröffentlicht ist. In diesem Artikel wird von den Autoren schon die Vermutung geäußert (Seite 855, linke Spalte), dass die Drift der Lithium- Ionen an dem für die Oxidation benötigten Ladungstransport teilhat. Am Ende des Artikels weisen die Autoren auch darauf hin, dass mit dieser thermoelektrischen Oxidation auch die Reinigung nominell reiner Kristalle möglich sein könnte. Allerdings geht aus Figur 4 des Artikels hervor, dass sich eine Änderung im Absorptionsverhalten des Kristalls bei Konzentrationen unterhalb von 0,05 wt% Fe₂O₃ nicht mehr anhand eines Absorptionsspektrums beobachten lässt. Auch sonst sind keine Messungen bekannt, an denen sich der reinigende Effekt der Oxidation unmittelbar am Kristall nachweisen lässt. Eine Optimierung der für das Verfahren der Reinigung nominell reiner Kristalle einzustellenden Parameter lässt sich somit an solchen Kristallen nicht unmittelbar durchführen.

Die im Rahmen der Erfindung durchgeführten Untersuchungen zeigten jedoch den erstaunlichen Effekt, dass sich die an dotierten Kristallen gefundenen Parameter auf die nominell reinen Kristalle übertragen lassen, solange die oben genannten kleineren Temperaturanstiege gewählt werden. Das erfindungsgemäße Verfahren ist somit im Prinzip durch folgende zwei wesentliche Merkmale ausgezeichnet, nämlich "wähle einen Temperaturanstieg von kleiner 3°C pro Minute" und "bestimme für die Oxidation wesentliche Parameter anhand von dotierten Referenzkristallen und wende diese Parameter auf die nominell reinen Kristalle an". Dabei wird, wie gesagt, zunächst als wesentlicher Parameter der Schwellwert angesehen, der durch die Temperatur gegeben ist, bei der die Wanderung von im Kristall vorhandenen Ionen, insbesondere von Li⁺-Ionen, hin zur Oberfläche des Kristalls abgeschlossen ist. Am Ende ihrer Wanderung rekombinieren die Ionen an der Oberfläche des Kristalls mit Elektronen der Fremdatome, insbesondere mit Elektronen der Fe²⁺-Ionen, die dann als Fe³⁺-Ionen zurück bleiben oder mit Elektronen, die von der Stromversorgung bereit gestellt werden.

Als weitere Parameter können die anzulegende Spannung, der Stromfluss durch den Kristall, die Temperaturerhöhung pro Zeit, die Haltezeit der Maximaltemperatur, die Temperaturabsenkung pro Zeit, die Lichtwellenlänge und/oder die Lichtintensität an einem Referenzkristall ermittelt und auf den reinen Kristall übertragen werden.

Die Tatsache, dass die Parameter in der erfindungsgemäßen Form übertragbar sind, ist erstaunlich, da die Fachwelt bislang annahm, dass die Oxidation bei dotierten Kristallen wesentlich von der Elektronenwanderung getragen würde. Dotierte Kristalle enthalten im Vergleich zu reinen Kristallen mehr verfügbare Fremdatome, so dass die Elektronen den direkten Weg beispielsweise von Fe²⁺-Ion zu Fe³⁺-Ion nehmen können. Dieser Weg ist aber wegen der geringen Konzentration im Fall der nominell reinen Kristalle ausgeschlossen. Durch die Untersuchungen hat sich nun jedoch ergeben, dass im Gegensatz zur vorherrschenden Meinung auch bei den dotierten Kristallen die Ionenwanderung wesentlich zum Reinigungseffekt beiträgt. Erst dieses erstaunliche Ergebnis macht die Übertragung der an entsprechenden Referenzkristallen gefundenen Parameter auf die reinen Kristalle, in denen Elektronenwanderung nahezu ausgeschlossen ist, möglich.

Beim Ladungstransport insbesondere in Lithiumniobat und Lithiumtantalat muss auf Grund der Oxidation, hier von Fe²⁺ nach Fe³⁺, für das freigesetzte Elektron eine Ladungskompensation erfolgen. Dabei wird nach den Ergebnissen der Untersuchungen ein Elektron von einem Li⁺ -Ion eingefangen (Fe²⁺ → Fe³⁺: Li⁺ + e⁻ → Li⁰), so dass sich neutrales Lithium auf der Kristalloberfläche bildet

Für die Oxidation der reinen Kristalle ist es auch entscheidend, dass die Maximaltemperatur für eine gewisse Zeit, vorteilhafterweise für mehr als eine Stunde und insbesondere für mehr als fünf Stunden auf dem Niveau gehalten wird und dass der Kristall nach Erreichen und Halten der Maximaltemperatur mit zumindest annährend demselben Gradienten von weniger als 3°C pro Minute abgekühlt wird. Wie beim Heizen, so ist auch beim Kühlen eine Temperaturänderung von weniger als 2,5°C pro Minute vorteilhaft. Bei der kompletten Behandlung sollte die Spannungsquelle angeschaltet bleiben.

Im Gegensatz zu bekannten Verfahren ermöglicht es die erfindungsgemäße Behandlung, nahezu alle Ionen, die mit Elektronen gefüllt sind und deswegen unter Beleuchtung als Ladungsspender dienen können, durch Entfernung des im Hinblick auf den sogenannten optischen Schaden "schädlichen" Elektrons unschädlich zu machen. Vorteilhaft an dem erfindungsgemäßen Verfahren ist, dass sich das Verhältnis V um mehr als einen Faktor 10 gegenüber der konventionellen Oxidation an Luft oder in Sauerstoffatmosphäre senken lässt, was die Robustheit der Kristalle gegen den optischen Schaden entsprechend erhöht. Dabei ist es auch wesentlich, dass das äußere elektrische Feld nicht nur bei einer konstanten Temperatur der Probe, sondern während der besonders langsamen Temperaturänderungen angelegt wird.

Im Hinblick auf eine möglichst vollständige Oxidation ist es zudem vorteilhaft, wenn der Kristall während der thermischen Behandlung zusätzlich noch mit Licht einer Photonenenergie bestrahlt wird, die ausreichend ist, um Ladungen aus den Störstellen anzuheben und damit die Entfernung der Elektronen zu begünstigen. Vorteilhafterweise wird der Kristall daher während der thermischen Behandlung mit Licht einer Wellenlänge aus dem Bereich zwischen UV und Grün (< 550 nm) bestrahlt. Mit dem Einsatz des erfindungsgemäßen Verfahrens ist nachweislich eine dauerhafte Verhinderung oder zumindest eine deutliche Verminderung des optischen Schadens gegeben.

Für die an den dotierten Kristallen durchzuführenden Untersuchungen zur Feststellung der Parameter werden zunächst zwei unterschiedliche Verfahren vorgeschlagen. Dabei bedient sich das erste Verfahren einer optischen und das zweite Verfahren einer elektrischen Untersuchung am dotierten Kristall. So hat sich gezeigt, dass der Kristall für hinreichend hohe Fe-Dotierungen bei der Umwandlung von Fe²⁺ zu Fe³⁺ transparent wird und dass sich die während des Temperaturintervalls vollzogene Wanderung der Ionen durch den Kristall in einer sichtbaren oder einer darstellbaren Oxidationsphasenfront manifestiert, die sich durch den Kristall hindurch bewegt. Diese Bewegung kann mit einfachen Mitteln beobachtet und registriert werden. Erfindungsgemäß werden am dotierten Kristall die Parameter so optimiert, dass eine komplette Wanderung stattfindet, die zu einer möglichst homogenen Änderung des Brechungsindex oder des Absorptionsverhaltens im Kristall führt. Die so aufgefundenen Parameter werden auf die Behandlung der reinen Kristalle übertragen.

Das zweite an den Referenzkristallen durchzuführende Verfahren zur Ermittlung der Parameter sieht vor, den sich während des Heizens ändernden elektrischen Widerstand am Kristall zu registrieren, wobei dieser innerhalb des spezifischen Temperaturintervalls insofern eine "Anomalie" zeigt, als er dort ansteigt und bei weiter steigender Temperatur wieder abfällt. Die Spannung bildet demnach einen kleinen Peak in der ansonsten stetig fallenden Kurve aus. Der Peak in der Strom-Spannungskennlinie, der bei dotierten Kristallen mit herkömmlichen Messgeräten zu beobachten ist, deutet auf eine Anomalie im Ladungstransport hin, die mit der Ionenwanderung und der Ausbreitung der Oxidationsphasenfront zu erklären ist. Da die Oxidationsphasenfront an der Spitze des Peaks noch nicht vollständig durch den Kristall hindurch gewandert ist, muss die Heizrampe weiter stetig erhöht werden, damit der Diffusionsprozess genug Zeit hat, zum Ende zu gelangen. Andernfalls ist der Kristall nicht homogen und vollständig oxidiert oder die Phasenfront bleibt im Kristall stehen. Restbereiche, die nicht komplett durchoxidiert sind, sind an einer schwachen Färbung oder an Streifen im ansonsten klaren Kristall zu erkennen. Insofern kann die Ausmessung des Peaks, den der elektrische Widerstands während eines Heizvorgangs ausbildet, als Indikator für die erfolgreiche einsetzende Oxidation verwendet werden.

Besonders vorteilhaft ist es, wenn bei der Durchführung des erfindungsgemäßen Verfahrens ein Computer eingesetzt wird. Dieser kann für die Registrierung der Parameter während der Untersuchungen an den Referenzkristallen dienen und/oder die Steuerung der Behandlung, also die Einstellung der Parameter während der Behandlung übernehmen.

Besonders vorteilhaft lassen sich die erfindungsgemäß behandelten reinen Kristalle in optischen insbesondere in nichtlinear-optischen Bauteilen einsetzen. Mit Bauteilen, in denen erfindungsgemäß behandelte nichtlinear-optische Kristalle integriert sind, kann nunmehr auch intensives Laser-Licht in unterschiedlicher Weise beeinflusst werden, ohne dass "optical damage" die Funktion beeinträchtigt. So kann im Rahmen einer "second harmonic generation" (SHG) die Frequenz des eingestrahlten Lichtes verdoppelt werden. Außerdem lassen sich zwei Frequenzen subtraktiv und additiv mischen ("up-conversion", "down-conversion"). Weiterhin sind die Kristalle in optisch parametrischen Oszillation (OPOs) vorteilhaft einsetzbar, in denen eine Pumpwelle der Frequenz ω_{P} in eine Signalwelle der Frequenz ω_{S} und eine Idler-Welle der Frequenz ω_{I} zerlegt wird. Mit Hilfe dieser Bauteile kann Laser-Licht in einem großen Bereich des elektromagnetischen Spektrums erzeugt werden, das sich vom UV über den sichtbaren bis in den infraroten Bereich erstreckt.

Um bei der hohen Eingansintensität, die mit heutigen Lasern zur Verfügung steht, auch eine hohe Ausgangsintensität zu erhalten, ist der erfindungsgemäß behandelte Kristall von größter Bedeutung, wobei sowohl Einkristalle als auch periodisch gepolte Kristalle in den Bauteilen eingesetzt werden können. Unabhängig von der Art des Kristalls darf dieser bei hohen Laserintensitäten den Pumpstrahl nicht beeinflussen, da ansonsten die Abbildungseigenschaften des Bauteils verloren gehen. Insbesondere würde ein Resonator instabil werden. Damit die gereinigten Kristalle hinreichende Effizienz für die Frequenzverdopplung und Frequenzmischung aufweisen, ist es vorteilhaft, sie entsprechend periodisch zu polen (PPLN = Perodically Poled Lithium Niobate).

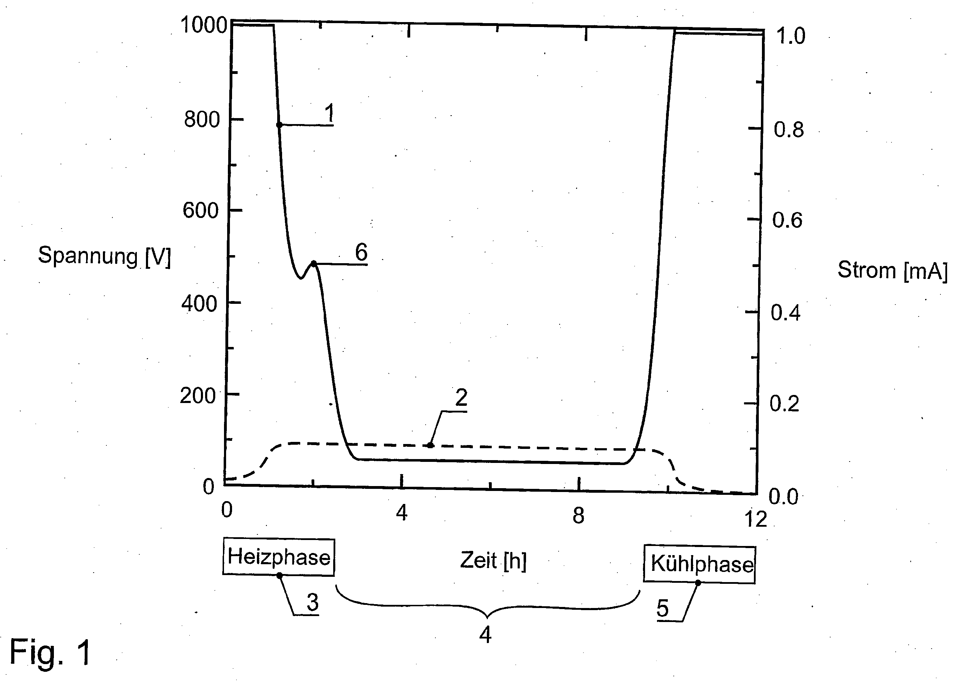

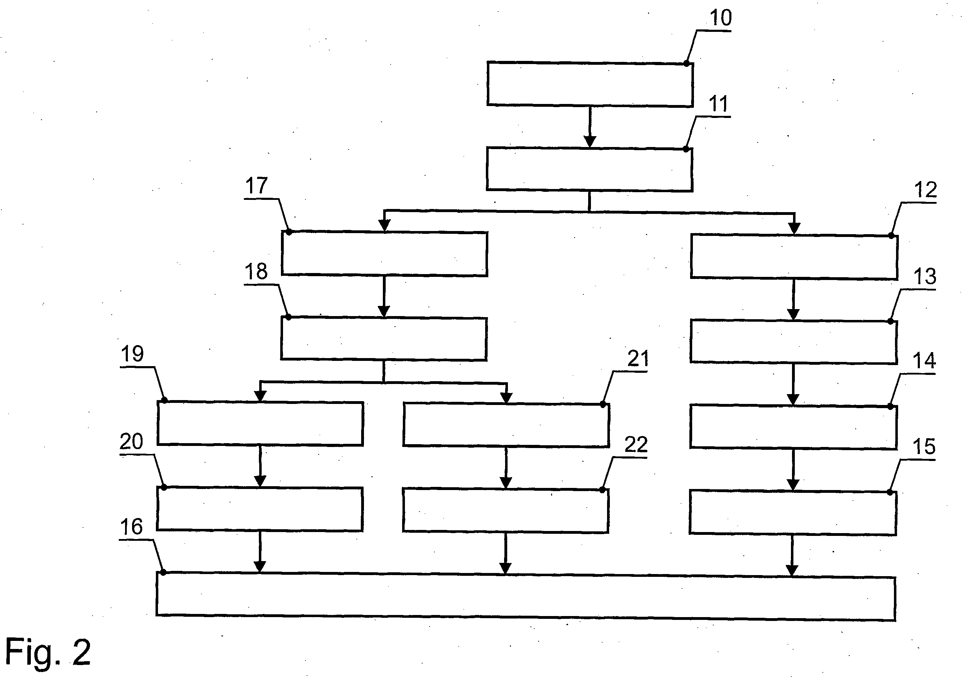

Das erfindungsgemäße Verfahren wird nachfolgend anhand der Figuren 1 und 2 erläutert. Die Figuren zeigen:
- **Figur 1**: eine Kurve, welche die Abhängigkeit von Strom und Spannung während der Behandlung an einem Kristall zeigt,
- **Figur 2**: eine Zusammenstellung möglicher Behandlungsschritte,
- **Figur 3**: ein Schema eines Frequenzkonverters und
- **Figur 4**: Prinzipskizzen verschiedener nichtlinear-optischer Bauteile.

In Figur 1 ist am Beispiel eines mit 2 wt% Fe₂O₃ dotierten LiNbO₃-Kristalls in normaler Luftatmosphäre und bei Normaldruck der Spannungsverlauf 1 und der Stromverlauf 2 während einer etwa dreistündigen Heizphase 3, einer etwa sechsstündigen Haltephase 4 und einer etwa wiederum dreistündigen Kühlphase 5 gezeigt. In der Heizphase und der Kühlphase sieht sich der Kristall einem positiven respektive einem negativen Temperaturgradienten von 3°C pro Minute ausgesetzt, wobei eine Maximaltemperatur von 700°C erreicht wird. Während der gesamten Behandlung ist über am Kristall angebrachten Elektroden eine Spannung von 1000 Volt angelegt, bei der ein maximaler Strom von ca. 0,1 mA fließt. Zum Halt des Stromes ist eine Strombegrenzung auf 0,1 mA eingestellt, wobei nach Überschreiten der Strombegrenzung während des Heizens die angelegte Spannung entsprechend reduziert wird. Der in Figur 1 dargestellte Verlauf ist bezüglich der Heiz- und der Kühlphase symmetrisch.

Aus der Figur ist ersichtlich, dass es während der Heizphase 3 vorübergehend zu einer Erhöhung des elektrischen Widerstands im Kristall kommt. Diese Erhöhung manifestiert sich in einem lokalen Peak 6 in der Spannungskurve nach etwa 2 Stunden. Dieser Peak 6 ist auf die Entfernung der beweglichen Elektronen durch die Oxidation zurückzuführen. Die an dem dotierten Kristall bestimmten Parameter werden erfindungsgemäß auf nominell undotierte LiNbO₃-Kristalle angewendet, die Eisen nur als Verunreinigung enthalten. Als Temperaturgradient wird dann allerdings 2°C pro Minute eingestellt.

Zusätzlich kann der Kristall mit Licht der Intensität I_{A} und der Wellenlänge λ_{A} zur Anregung der Elektronen in das Leitungsband bestrahlt werden. Für die Oxidation entscheidend ist das Zusammenwirken von Heizrate, Haltetemperatur, Haltezeit, Kühlrate, Strom, Spannung, Intensität und Wellenlänge des Lichts. Dabei sind diese Parameter für jedes zu oxidierende chemische Element entsprechend einzustellen. Diese sind materialspezifisch und hängen zudem von der Zusammensetzung der umgebenden Atmosphäre ab.

In Figur 2 sind verschiedene Entwicklungen eines nominell reinen Kristalls von der Züchtung bis zum gereinigten PPLN ("periodically poled lithium niobate") aufgezeigt. Allen Entwicklungen gemeinsam ist zunächst die Zucht 10 eines Lithiumniobat-Kristalls zu einem fertigen "boule". In Schritt 11 wird der "boule" mit Elektroden versehen und bei einem Stromfluss von etwa 1 µA / cm² in einem Ofen bei einer Temperatur etwas unterhalb der Curietemperatur gepolt. In diesem Zustand bestehen zwei Möglichkeiten der weiteren Behandlung.

Der gepolte "boule" kann komplett dem erfindungsgemäßen Reinigungsverfahren der Superoxidation (Schritt 12) zugeführt werden, wobei es von Vorteil ist, wenn sich die Reinigung unmittelbar an den Schritt 11 anschließt und der "boule" im Ofen verbleibt. Damit würden die getrennten Schritte 11 und 12 zu einem gemeinsamen vereinheitlicht. Nachfolgend wird der "boule" in Schritt 13 in Wafer geschnitten, die poliert werden, bevor in einem lithographischen Prozess 14 eine periodische Polung vorgenommen wird. Die beschriebenen Wafer werden dann in Schritt 15 in die einzelnen Bauteile geschnitten, die dann fertige PPLN-Kristalle 16 ohne optischen Schaden darstellen.

In einer anderen Art der Bearbeitung werden nach Schritt 11 zunächst die Wafer geschnitten und poliert (Schritt 17) und der lithographischen Behandlung 18 unterzogen. Danach können entweder die einzelnen Bauteile einer Größe von beispielsweise 15 mm * 50 mm geschnitten werden (Schritt 19), bevor diese fertigen Bauteile letztendlich in Schritt 20 einzeln der erfindungsgemäßen Superoxidation unterzogen werden. Danach sind wiederum fertige PPLN-Kristalle 16 ohne optical damage entstanden. Es ist aber auch möglich, die beschriebenen Wafer zu reinigen (Schritt 21) und nach der Reinigung zu zerschneiden (Schritt 22). Wiederum liegen danach fertige PPLN-Kristalle 16 vor. Ein solcher PPLN-Kristall, mit dem eine Frequenzkonversion möglich ist, wird in Figur 3 gezeigt.

Der Einsatz von PPLN Kristallen in optischen Bauteilen ist aus folgendem Grund vorteilhaft: So hängt insbesondere die Fähigkeit zur Frequenzverdopplung von der Länge des Lichtweges im Kristall ab. Sie steigt bis zu einem Maximum an und fällt dann wieder auf Null ab. Der Kristall darf daher nur genau die optimale Dicke oder ganzzahlige Vielfache davon haben. In PPLN-Kristallen wird die Richtung der Polarisierung durch ein externes Feld eingestellt. Die Ausbreitung des Lichts muss senkrecht zu dieser Polarisierung erfolgen. Wenn jetzt das frequenzverdoppelte Licht ein Maximum bezüglich der Kristalllänge erreicht hat, wird dem Lichtstrahl ein Kristall mit entgegengesetzter Polarisierung angeboten. Hier beginnt auf dem bereits vorhandenen Niveau die Verdopplung erneut, so dass zu dem vorhandene verdoppelten Licht jetzt weiteres erzeugt wird. Dieser Effekt wiederholt sich von Pol zu Pol. Um eine große Effizienz zu erhalten, werden lange periodisch gepolte Kristalle, insbesondere Längen zwischen 40 mm und 50 mm, und hohe Laserintensitäten eingesetzt.

Der Kristall des Frequenzkonverters nach Figur 3 hat eine Länge in x-Richtung von 50 mm und eine Höhe z von 1 mm. In der Tiefe y hat der Kristall eine Ausdehnung von 15 mm. In diesem Fall sind auf die Länge von 50 mm zwölf gegenläufige Perioden der Polarisierung aufgeprägt, wobei die Richtungen jeweils durch Pfeile dargestellt sind. Das bedeutet, dass der Kristall entsprechend zwölf verschiedene Periodenlängen bezüglich der Polarisierung, also zwölf verschiedene Längen aufweist. Die Variation der austretenden Wellenlänge wird durch Steuermittel, die äußere Parameter insbesondere die Temperatur des PPLN-Kristalls verändern, erreicht. Damit kann mit einem Pumplaser einer festen Wellenlänge bei Verwendung von PPLN Laserlicht im Spektralbereich von ca. 350 nm bis 5µm erzeugt werden.

In den Kristall wird in diesem Fall ein intensiver Laserstrahl 32 mit einer Frequenz im Bereich des IR eingestrahlt. Als Ausgangsstrahlung tritt die IR Strahlung 33 und blaue Strahlung 34 aus. Die Oberflächen des Kristalls sind noch bedeckt von Elektroden 31, mit denen Ausheilungen durchgeführt werden können. Die Elektroden 31 können später entfernt werden.

In Figur 4 sind Ausführungsbeispiele optischer nichtlinearer Bauteile gezeigt. Mit einem Laser 40, beispielsweise einer einmodigen Laserdiode, einem Faserlaser oder einem Festkörperlaser, wird jeweils ein Pumpstrahl der Frequenz ω erzeugt. Im Falle der Frequenzverdopplung nach Beispiel A wird dieser direkt mit einer Linse 41 in den erfindungsgemäßen PPLN-Kristall 42 fokussiert, so dass die Ausgangsstrahlung 43 die Pumpstrahlung der Wellenlänge w und der verdoppelten Wellenlänge 2ω aufweist.

Nach Beispiel B wird eine Frequenzverdopplung dadurch verursacht, dass der erfindungsgemäß behandelte PPLN Kristall 43 in einem Resonator steht. Der Resonator besteht aus dem Spiegel des Pumplasers und einem externen zusätzlichen Spiegel 44. Dieser reflektiert die Pumpwellenlänge nahezu zu 100%, so dass nur noch das verdoppelte Licht 2 ω austritt. Mit dieser Anordnung können höhere Ausgangsintensitäten und bessere Intensitätsstabilitäten erzeugt werden.

Beispiel C zeigt die Summen- respektive die Differenzfrequenzmischung beim Eintritt von zwei Wellen verschiedener Frequenzen ω1 und ω2. Mit einem einmaligen Durchlauf wird ein Strahl 45 der Frequenz ω1 - w2 oder ω1 + w2 erzeugt, während die Pumpstrahlen ω1 und ω2 erhalten bleiben.

In Beispiel D ist ein Optischer-Parametrischer-Oszillator realisiert. Der PPLN-Kristall befindet sich dafür in einem externen Resonator zwischen zwei Spiegeln 46 und 47 und wird mit Licht der Pump-Frequenz ω_{P} beleuchtet. Im Resonator entstehen zwei neue Wellen mit der Signal-Frequenz ω_{S} und der Idler-Frequenz ω_{I} wobei gilt: ω_{P} = ω_{S} + ω_{I}.

## Patentansprüche

1. Verfahren zur Behandlung eines nominell reinen Kristalls mit nichtlinearoptischen Eigenschaften, nämlich eines Lithiumniobat- oder Lithiumtantalat-Kristalls, wobei im Kristall Fremdatome mit einer Restkonzentration weniger 20 ppm, insbesondere Fe²⁺-Ionen, vorhanden sind, die eine spezifische Absorption von eingestrahltem Licht bewirken, wobei die Fremdatome durch eine thermisch unterstützte Oxidation in einen höheren Valenzzustand, insbesondere in Fe³⁺-Ionen, überführt werden, wobei die bei der Oxidation frei werdenden Elektronen durch Anlegen einer elektrischen Spannung aus dem Kristall abgeführt werden,
**dadurch gekennzeichnet,**
**dass** der Kristall mit einem Temperaturanstieg von weniger als 3°C pro Minute auf eine Maximaltemperatur aufgeheizt wird, die oberhalb eines vorgegebenen Schwellwertes und unterhalb der Curie-Temperatur des Kristalls liegt, wobei der Schwellwert gegeben ist durch die Temperatur, bei der die Wanderung von im Kristall vorhandenen Ionen, insbesondere von Li⁺-Ionen, hin zur Oberfläche des Kristalls abgeschlossen ist, wobei der Schwellwert anhand von vorherigen Untersuchungen an gezielt dotierten Referenzkristallen der gleichen Art bestimmt wird.

2. Verfahren nach Anspruch 1,
**dadurch gekennzeichnet, dass** der Schwellwert am Ende eines spezifischen Temperaturintervalls liegt, in dem die Ionenwanderung stattfindet, wobei innerhalb des Temperaturintervalls ein kontinuierlicher und stetiger Temperaturanstieg erzeugt wird.

3. Verfahren nach Anspruch 1,
**dadurch gekennzeichnet, dass** an den Referenzkristallen neben dem Schwellwert weitere Parameter für die thermisch unterstützte Oxidation bestimmt werden, wobei die Behandlung der nominell reinen Kristalle anhand dieser Parameter durchgeführt wird.

4. Verfahren nach einem der vorherigen Ansprüche,
**dadurch gekennzeichnet,**
**dass** die Untersuchungen an Referenzkristallen durchgeführt werden, die mit einer Konzentration von mehr als 0,1 wt % Fremdatomen dotiert sind.

5. Verfahren nach einem der vorherigen Ansprüche,
**dadurch gekennzeichnet, dass** im Rahmen der Untersuchung die Änderung des Brechungsindex und/oder die Änderung des Absorptionsverhaltens des Referenzkristalls registriert wird, wobei sich die Änderung während des Temperaturintervalls als sichtbare oder darstellbare Front durch den Kristall bewegt.

6. Verfahren nach einem der vorherigen Ansprüche,
**dadurch gekennzeichnet, dass** im Rahmen der Untersuchung der sich während des Heizens ändernde Widerstand am Kristall registriert wird, wobei der elektrische Widerstand innerhalb des spezifischen Temperaturintervalls ansteigt und bei weiter steigender Temperatur wieder abfällt.

7. Verfahren nach einem der vorherigen Ansprüche,
**dadurch gekennzeichnet, dass** die Maximaltemperatur für mehr als eine Stunde, insbesondere für mehr als fünf Stunden, gehalten wird.

8. Verfahren nach Anspruch 7,
**dadurch gekennzeichnet, dass** der Kristall nach Erreichen und Halten der Maximaltemperatur mit zumindest annährend demselben Gradienten von weniger als 3°C pro Minute abgekühlt wird, wobei die Spannungsquelle angeschaltet bleibt.

9. Verfahren nach einem der vorherigen Ansprüche,
**dadurch gekennzeichnet, dass** beim Heizen und beim Kühlen eine Temperaturänderung von weniger als 2,5°C pro Minute gewählt wird.

10. Verfahren nach einem der vorherigen Ansprüche,
**dadurch gekennzeichnet, dass** der Kristall während der Temperaturbehandlung mit Licht einer Wellenlänge aus dem Bereich zwischen UV und Grün (< 550 nm) bestrahlt wird.

11. Verfahren nach Anspruch 3,
**dadurch gekennzeichnet, dass** als weitere Parameter die anzulegende Spannung und/oder der Stromfluss durch den Kristall und/oder die Temperaturerhöhung pro Zeit und/oder die Haltezeit der Maximaltemperatur und/oder die Temperaturabsenkung pro Zeit und/oder die Lichtwellenlänge und/oder die Lichtintensität an den Referenzkristallen ermittelt werden.

12. Verfahren nach einem der vorherigen Ansprüche,
**dadurch gekennzeichnet, dass** die Untersuchung der Referenzkristalle automatisch von einem Computer vorgenommen wird.

13. Verfahren nach einem der vorherigen Ansprüche,
**dadurch gekennzeichnet, dass** die Einstellung der Parameter automatisch von einem Computer vorgenommen wird.

## Claims

1. A method for treating a nominally pure crystal with non-linear optical properties, namely a lithium niobate or lithium tantalate crystal, wherein impurity atoms with a residual concentration of less than 20 ppm, in particular Fe²⁺ ions are present in the crystal, which cause a specific absorption of irradiated light, wherein the impurity atoms are transferred by means of a thermally aided oxidation process into a higher valence state, in particular into Fe³⁺ ions, wherein the electrons that are freed during the oxidation process are led out of the crystal by the application of an electrical voltage,
**characterised in that**
the crystal is heated with a temperature rise of less than 3°C per minute to a maximum temperature that lies above a prescribed threshold value and below the Curie temperature of the crystal, wherein the threshold value is given by the temperature at which the migration of ions present in the crystal, in particular of Li⁺ ions, to the surface of the crystal is completed, wherein the threshold value is determined on the basis of previous studies on specifically doped reference crystals of the same type.

2. The method in accordance with claim 1, **characterised in that** the threshold value lies at the end of a specific temperature interval in which the ion migration takes place, wherein within the temperature interval a continuous and steady temperature rise is generated.

3. The method in accordance with claim 1, **characterised in that** on the reference crystals, in addition to the threshold value, further parameters for the thermally aided oxidation process are determined, wherein the treatment of the nominally pure crystals is executed on the basis of these parameters.

4. The method in accordance with one of the preceding claims, **characterised in that** the studies are executed on reference crystals that are doped with a concentration of more than 0.1% by weight of impurity atoms.

5. The method in accordance with one of the preceding claims, **characterised in that** in the context of the study, the alteration of the refractive index and/or the alteration of the absorption behaviour of the reference crystal is registered, wherein during the temperature interval the alteration moves through the crystal as a visible or representable front.

6. The method in accordance with one of the preceding claims, **characterised in that** in the context of the study the resistance on the crystal altering during the heating process is registered, wherein the electrical resistance rises within the specific temperature interval, and in the event of the temperature rising further, it falls once again.

7. The method in accordance with one of the preceding claims, **characterised in that** the maximum temperature is maintained for more than one hour, in particular for more than five hours.

8. The method in accordance with claim 7, **characterised in that** after the maximum temperature has been achieved and maintained, the crystal is cooled with at least approximately the same gradient of less than 3°C per minute, wherein the voltage source remains switched on.

9. The method in accordance with one of the preceding claims, **characterised in that** during the heating and cooling processes a temperature variation of less than 2.5°C per minute is selected.

10. The method in accordance with one of the preceding claims, **characterised in that** during the temperature treatment the crystal is radiated with light at a wavelength from the range between UV and green (< 550 nm).

11. The method in accordance with claim 3, **characterised in that** the voltage to be applied, and/or the current flow through the crystal, and/or the temperature increase per unit time, and/or the time maintained at the maximum temperature, and/or the temperature decrease per unit time, and/or the light wavelength, and/or the light intensity on the reference crystals are determined as further parameters.

12. The method in accordance with one of the preceding claims, **characterised in that** the study of the reference crystals is automatically undertaken by a computer.

13. The method in accordance with one of the preceding claims, **characterised in that** the adjustment of the parameters is automatically undertaken by a computer.

## Revendications

1. Procédé pour le traitement d'un cristal nominalement pur avec des propriétés optiques non linéaires, à savoir d'un cristal de niobate de lithium ou de tantalate de lithium, dans lequel des atomes étrangers sont présents dans le cristal avec une concentration résiduelle de moins de 20 ppm, en particulier des ions Fe²⁺, lesquels produisent une absorption spécifique de la lumière injectée, dans lequel on fait passer les atomes étrangers à un état de valence supérieure grâce à une oxydation assistée thermiquement, en particulier à des ions Fe³⁺, dans lequel les électrons se libérant lors de l'oxydation sont évacués du cristal par application d'une tension électrique, **caractérisé en ce que** le cristal est chauffé avec une augmentation de température de moins de 3°C par minute à une température maximale, laquelle est supérieure à une valeur de seuil prescrite et inférieure à la température de Curie du cristal, dans lequel la valeur de seuil est donnée par la température à laquelle la migration d'ions présents dans le cristal, en particulier des ions Li⁺, vers la surface du cristal se termine, dans lequel la valeur de seuil est déterminée à l'aide d'analyses préalables effectuées sur des cristaux de référence du même type dopés de manière ciblée.

2. Procédé selon la revendication 1, **caractérisé en ce que** la valeur de seuil se situe à la fin d'un intervalle de températures spécifique dans lequel la migration des ions a lieu, dans lequel une augmentation continue et régulière de la température est produite à l'intérieur de l'intervalle de températures.

3. Procédé selon la revendication 1, **caractérisé en ce qu'** au niveau des cristaux de référence, on détermine, en plus de la valeur de seuil, d'autres paramètres pour l'oxydation assistée thermiquement, dans lequel le traitement des cristaux nominalement purs est effectué à l'aide de ces paramètres.

4. Procédé selon l'une des revendications précédentes, **caractérisé en ce que** les analyses sont effectuées au niveau de cristaux de référence qui sont dopés avec des atomes étrangers avec une concentration de plus de 0,1 % en poids.

5. Procédé selon l'une des revendications précédentes, **caractérisé en ce que**, dans le cadre de l'analyse, la modification de l'indice de réfraction et/ou la modification du comportement d'absorption du cristal de référence sont enregistrées, dans lequel, pendant l'intervalle de température, la modification se déplace en tant que front visible ou représentable à travers le cristal.

6. Procédé selon l'une des revendications précédentes, **caractérisé en ce que**, dans le cadre de l'analyse, on enregistre la résistance variant au niveau du cristal pendant le chauffage, dans lequel la résistance électrique augmente à l'intérieur de l'intervalle de températures spécifique et baisse de nouveau avec une température continuant d'augmenter.

7. Procédé selon l'une des revendications précédentes, **caractérisé en ce que** la température maximale est conservée pendant plus d'une heure, en particulier pendant plus de cinq heures.

8. Procédé selon la revendication 7, **caractérisé en ce que**, après avoir atteint la température maximale et l'avoir conservée, le cristal est refroidi au moins avec approximativement le même gradient de moins de 3°C par minute, moyennant quoi la source de tension reste allumée.

9. Procédé selon l'une des revendications précédentes, **caractérisé en ce que**, lors du chauffage et du refroidissement, on sélectionne une variation de température de moins de 2,5°C par minute.

10. Procédé selon l'une des revendications précédentes, **caractérisé en ce que**, pendant le traitement thermique, le cristal est irradié avec de la lumière d'une longueur d'onde dans la plage comprise entre l'UV et le vert (<550 nm).

11. Procédé selon la revendication 3, **caractérisé en ce que**, en guise d'autres paramètres, on détermine la tension à appliquer et/ou le flux de courant à travers le cristal et/ou l'augmentation de la température dans le temps et/ou le temps de conservation de la température maximale et/ou la baisse de la température dans le temps et/ou la longueur d'onde de lumière et/ou l'intensité de la lumière au niveau des cristaux de référence.

12. Procédé selon l'une des revendications précédentes, **caractérisé en ce que** l'analyse des cristaux de référence est effectuée automatiquement par un ordinateur.

13. Procédé selon l'une des revendications précédentes, **caractérisé en ce que** le réglage des paramètres est effectué automatiquement par un ordinateur.
